(19) Europäisches Patentamt
European Patent Office
Office européen des brevets

(11) **EP 1 517 356 B1**

(12) **EUROPEAN PATENT SPECIFICATION**

(45) Date of publication and mention
of the grant of the patent:
**04.03.2009 Bulletin 2009/10**

(51) Int Cl.:
***H01J 37/317*** *(2006.01)*    ***G11B 7/26*** *(2006.01)*
***G02B 5/18*** *(2006.01)*

(21) Application number: **04255329.7**

(22) Date of filing: **02.09.2004**

(54) **Electron-beam lithography method and device**

Apparat und Verfahren für die Elektronenstrahllithografie

Appareil et méthode pour la lithographie avec faisceaux d'éléctrons

(84) Designated Contracting States:
**DE ES FR GB IT NL**

(30) Priority: **10.09.2003 JP 2003318204**

(43) Date of publication of application:
**23.03.2005 Bulletin 2005/12**

(73) Proprietor: **Ricoh Company, Ltd.**
**Tokyo 143-8555 (JP)**

(72) Inventor: **Fujiwara, Yasuhide**
**Atsugi-shi**
**Kanagawa (JP)**

(74) Representative: **Lamb, Martin John Carstairs**
**Marks & Clerk**
**90 Long Acre**
**London WC2E 9RA (GB)**

(56) References cited:
**EP-A- 1 267 340**      **US-A- 3 542 453**
**US-B1- 6 414 916**

• **SHIRO OGATA ET AL: "ELECTRON-BEAM
WRITING SYSTEM AND ITS APPLICATION TO
LARGE AND HIGH-DENSITY DIFFRACTIVE
OPTIC ELEMENTS" APPLIED OPTICS, OSA,
OPTICAL SOCIETY OF AMERICA,
WASHINGTON, DC, US, vol. 33, no. 10, 1 April
1994 (1994-04-01), pages 2032-2038,
XP000434215 ISSN: 0003-6935**

**Description**

BACKGROUND OF THE INVENTION

1. Field of the Invention

The present invention relates to a method and device of electron-beam lithography suitable for fabricating a diffraction grating, a Fresnel lens, a photonic crystal, or other optical elements with an electron beam.

2. Description of the Related Art

In the related art, a diffraction grating, a Fresnel lens, and the like are fabricated in the following way. First, expose a resist by interference lithography to form a pattern, etch a substrate with the resist as a mask, form an inverted mold with the substrate as a mask, and then transfer the shape of the inverted mold to a resin or the like to form the desired optical element.

Recently and continuing, patterns used in fabrication of these optical elements are becoming more and more miniaturized, and hence, an electron-beam lithography apparatus is frequently used to irradiate a resist applied on a substrate with an electron beam to form a pattern, as disclosed in Japanese Laid-Open Patent Application No. 7-294730 (below, referred to as reference 1), and in Japanese Patent Gazette No. 2853659 (below, referred to as reference 2). Similarly, electron-beam lithography is also used when fabricating a photonic crystal.

Differing from a semiconductor element, an optical element usually has a relatively large area, for example, in a range from several $mm^2$ to several $cm^2$, and hence, relative positional accuracy inside the area is important when fabricating the optical element.

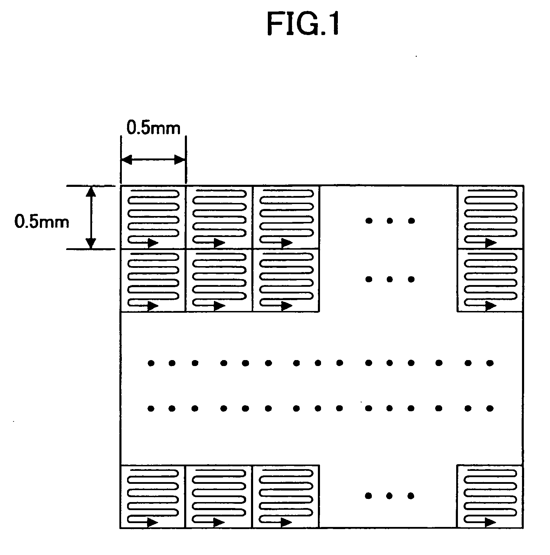

FIG. 1 is view showing an example of the electron-beam lithography method in the related art.

As illustrated in FIG. 1, an electron beam is deflected in x or y directions to expose a predetermined portion of a surface of a substrate. This predetermined portion is referred to as a "unit exposure field", defined to be a region able to be exposed by only deflecting the electron beam without moving a sample stage (or called xy stage) that supports the substrate.

If the xy stage (sample stage) is moved in x directions and y directions repeatedly, many unit exposure fields can be exposed. In this way, a desired pattern can be formed. Below, this electron-beam lithography apparatus is referred to as "xy-stage lithography apparatus".

In the xy-stage lithography apparatus, the electron beam is deflected to scan the unit exposure field. If the electron beam is deflected too much, at ends of the unit exposure field, the electron beam becomes de-focused. For this reason, the area of the unit exposure field has to be limited to be small, for example, in the xy-stage lithography apparatus, the unit exposure field is at most 2 mm x 2 mm in area, and usually, only about 0.5 mm x 0.5 mm.

In addition to the limited area of the unit exposure field, there also exist uncertainties in positional alignment between adjacent unit exposure fields. For example, the highest position alignment precision of the xy-stage lithography apparatus is around 0.05 $\mu$m, and hence, at least uncertainty in position alignment at this level exists between unit exposure fields.

In the xy-stage lithography apparatus, the xy-stage is moved in the x or y directions. Other methods of moving a sample stage are also proposed. For example, in a disk lithography apparatus, a disk material of an optical disk is placed on a turning table, and an electron beam is incident on the disk material while the disk material is rotating to form a pattern on the disk material. Below, this kind of lithography apparatus is referred to as an "x$\theta$-stage lithography apparatus".

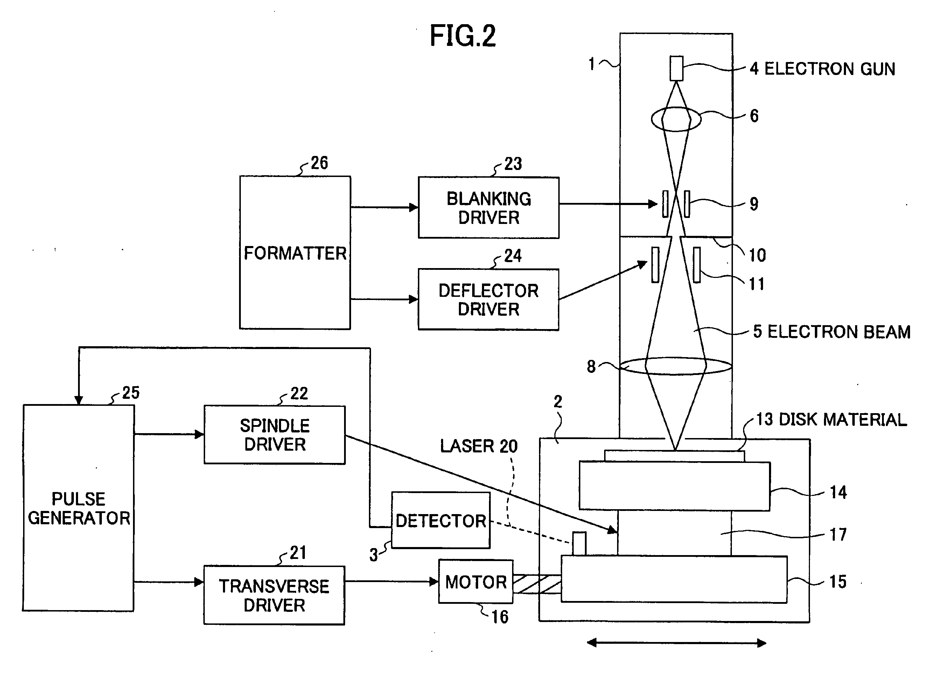

FIG. 2 is a schematic view of an exemplary configuration of the disk lithography apparatus.

In FIG. 2, the disk lithography apparatus includes a cylinder 1 and a sample chamber 2. In the cylinder 1, there are arranged an electron gun 4, an electromagnetic lens 6, blanking electrodes 9, a diaphragm 10, a deflector 11, and an electromagnetic lens 8. In the sample chamber 2, there are arranged a turning table 14 on which a disk material 13 is arranged, a spindle motor 17 that drives the turning table 14 to rotate, and a translational stage 15 that movably (in a sliding direction) supports the spindle motor 17.

An electron beam 5 is generated in the electron gun 4 and directed onto the disk material 13 by the electromagnetic lens 6, blanking electrodes 9, deflector 11, and the electromagnetic lens 8.

The disk lithography apparatus in FIG. 2 further includes a detector 3 that measures the position of the translational stage 15, a motor 16 that drives the translational stage 15, a transverse driver 21 that controls and drives the motor 16, a spindle driver 22 that controls and drives the spindle motor 17, a blanking driver 23 that controls and drives the blanking electrodes 9, a deflector driver 24 that controls and drives the deflector 11, a pulse generator 25 that outputs pulses to the transverse driver 21 and the spindle driver 22 based on the measurement results of the detector 3, and a formatter 26 that outputs control signals to the blanking driver 23 and the deflector driver 24.

The cylinder 1 is evacuated to a vacuum higher than $10^{-5}$ torr. The electron beam 5 generated in the electron gun 4 in the cylinder 1 is focused by the electromagnetic lens 6, and the size of the electron beam 5 is limited by the diaphragm 10.

At the focus point of the electron beam 5, the electron beam 5 is deflected intermittently by the blanking electrodes 9 according to a signal from the formatter 26 to switch the electron beam 5 ON or OFF. The electron beam 5 is then focused by the electromagnetic lens 8, and is directed to irradiate the disk material 13.

The disk material 13 is rotated, together with the turning table 14, at a preset linear velocity, while being moved along a radial direction at preset pitches by the translational stage 15. As a result, the electron beam 5 forms a spiral track on the disk material 13.

The electron beam 5 may also be deflected periodically by the deflector 11. In addition, precise position alignment is achievable by measuring the position of the translational stage 15 with the detector 3 when the translational stage 15 is moving.

Turning to the problem to be addressed by the present invention, as mentioned above, in the xy-stage lithography apparatus disclosed in reference 1 and reference 2, the unit exposure field, in which precise position alignment is achievable, is small, and it is not sufficient for forming an optical element.

Although the xy stage can be moved in x, y directions repeatedly to expose many unit exposure fields to form a pattern, in this case, position misalignment occurs between unit exposure fields.

When using the x$\theta$-stage lithography apparatus, which has a turning table, and if the x, y coordinates are transformed into x, $\theta$ coordinates, it is possible to expose a wide region with high precision. Japanese Laid-Open Patent Application No. 2000-207738 (below, referred to as reference 4) discloses an invention related to this technique.

If a laser beam is used for exposure in the x$\theta$-stage lithography apparatus, exposure can be carried out while modulating the flux of the laser beam along the radial directions, for example, by performing CAV (Constant Angular Velocity) control, to compensate for variation in the laser beam flux for exposure, which is attributed to the dependence of linear velocity on the radius.

In this case, because the flux of the laser beam at different exposure positions is constant, and angular positions can be accurately determined, it is easy to transform the x, y coordinates into the x, $\theta$ coordinates, thus, it is possible to form patterns of any kind of shapes with high precision over a wide exposure region.

If an electron beam is used in the x$\theta$-stage lithography apparatus, however, because it is difficult to precisely modulate the intensity of the electron beam, it is difficult to uniformly irradiate the whole disk material 13. Therefore, it is required to keep the linear velocity in the radial direction constant.

In order to keep the linear velocity in the radial direction constant, it may be attempted to drive the turning table by CLV (Constant Linear Velocity) control. However, because the rotational speed of the turning table changes continuously in CLV control, it is difficult to precisely determine the angular position.

As a result, with the x$\theta$-stage electron-beam lithography apparatus, it is difficult to form patterns of any kind of shape with high precision; furthermore, it is difficult to use the x $\theta$-stage electron-beam lithography apparatus to form optical elements.

As disclosed in reference 4, if the pattern has a circular shape, problems do not occur even when CAV control is used. However, because a lithography apparatus usually performs exposure in a rectangular region, it is required to transform x, y coordinates into x, $\theta$ coordinates, and uncertainties occur in this transformation.

US6414916 relates to a recording apparatus of master discs of optical discs which adjusts a position where a recording beam is irradiated onto the master disk. Ogata S. et al "Electron-beam writing system and its application to large and high density diffractive optic elements" Applied Optics, OSA, Optical Society of America vol. 33, no. 10, 1 April 1994, pages 2032-2038 describes an electron beam writing system having a stationary beam and a continuously spinning table.

## SUMMARY OF THE INVENTION

It is a general object of the present invention to solve one or more problems of the related art.

A specific object of the present invention is to provide an electron-beam lithography method and device capable of forming a pattern of any kind of shape with high precision in a large area.

According to a first aspect of the present invention, there is provided an electron-beam lithography method as set out in Claim 1. According to a second aspect of the invention, there is provided an electron-beam lithography method as set out in Claim 2. Preferred features of the first and second aspects are set out in Claims 3 to 7.

According to a third aspect of the invention, there is provided an apparatus as set out in Claim 8. According to a fourth aspect of the invention, there is provided an apparatus as set out in Claim 9.

According to the present invention, in an x $\theta$-stage electron-beam lithography apparatus, by controlling exposure by the electron beam according to time information relative to the reference angular position, it is possible to expose a large area without the problem in position alignment between adjacent exposure fields occurring in an xy-stage electron-beam lithography apparatus of the related art.

In addition, because the linear velocity at the reference angular position is maintained to be constant in the pattern exposure region, and the rotational speed is maintained to be constant in the pattern exposure region, any position inside in the pattern exposure region can be expressed accurately from time information obtained from the radius and the reference angular position, and it is possible to perform exposure in a large area with high precision.

In the xy-stage electron-beam lithography apparatus of the related art, small exposure fields are exposed one by one, and the xy stage has to be moved and stopped repeatedly. According to the present invention, it is essentially not necessary to stop rotation of the substrate during exposure, and therefore, it is possible to expose a large area quickly.

These and other objects, features, and advantages of the present invention will become more apparent from the following detailed description of preferred embodiments given with reference to the accompanying drawings.

## BRIEF DESCRIPTION OF THE DRAWINGS

FIG. 1 is view showing an example of a pattern formed according to an electron-beam lithography method of the related art;

FIG. 2 is a schematic view of an exemplary configuration of a disk lithography apparatus;

FIG. 3 is a schematic view showing an exemplary configuration of an electron-beam lithography apparatus according to a first embodiment of the present invention;

FIG. 4 is schematic view showing the process of forming a pattern by irradiating the substrate 30 with an electron beam while rotating the substrate 30;

FIG. 5 is a schematic view of a pattern exposed by using the electron-beam lithography method of the present embodiment;

FIG. 6 is a view of a coordinate system illustrating the relation expressed by the equation (1);

FIG. 7 is a schematic view of a pattern exposed by using an electron-beam lithography method according to a second embodiment of the present invention;

FIG. 8 is a schematic view showing the tracks of the electron beam 5 in the exposure region 18 and over the substrate 30 according to the present embodiment;

FIG. 9 is a schematic view showing tracks of the electron beam 5 in the exposure region 18 formed by an electron-beam lithography method according to a third embodiment of the present invention;

FIG. 10A is a perspective view of a diffraction grating formed by utilizing the methods of the second embodiment and the third embodiment;

FIG. 10B is a graph showing exposure dose when forming the diffraction grating in FIG. 10A;

FIG. 10C shows waveforms of exposure pulses for forming the diffraction grating in FIG. 10A;

FIG. 11 is a schematic view showing another example of a pattern exposed by using the electron-beam lithography methods of the present invention;

FIG. 12 is a schematic view showing an example of providing a plurality of exposure regions; and

FIG. 13 is a view of a photonic crystal wave guide path formed by the method shown in FIG. 12.

## DESCRIPTION OF THE PREFERRED EMBODIMENTS

Below, preferred embodiments of the present invention are explained with reference to the accompanying drawings.

### First Embodiment

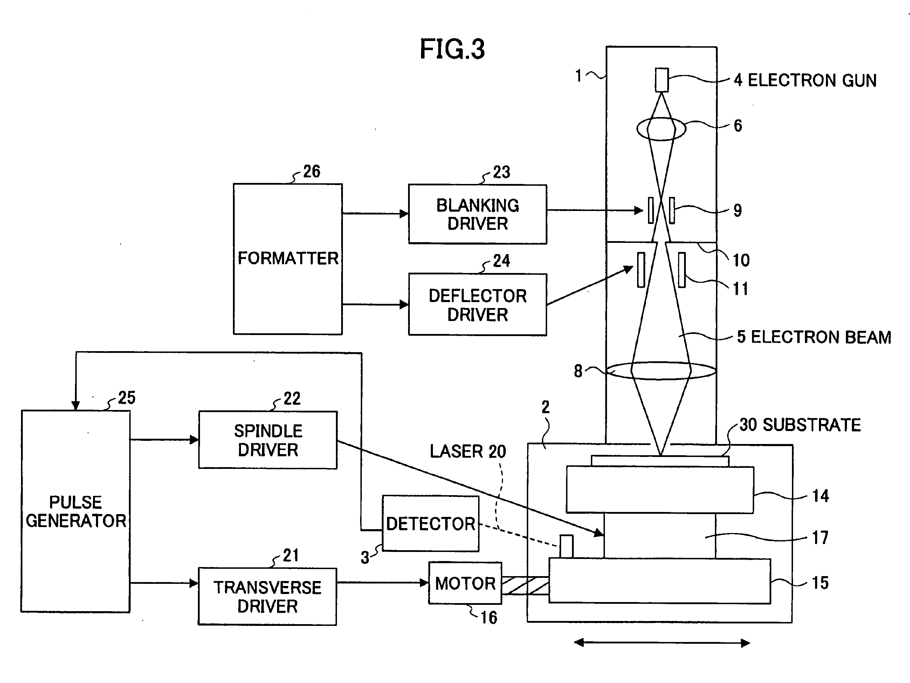

FIG. 3 is a schematic view showing an exemplary configuration of an electron-beam lithography apparatus according to a first embodiment of the present invention. In FIG. 3, the same reference numbers are used for the same elements as those shown in FIG. 2, and overlapping descriptions are omitted.

In FIG. 3, the reference number 30 designates a substrate on which a resist is applied.

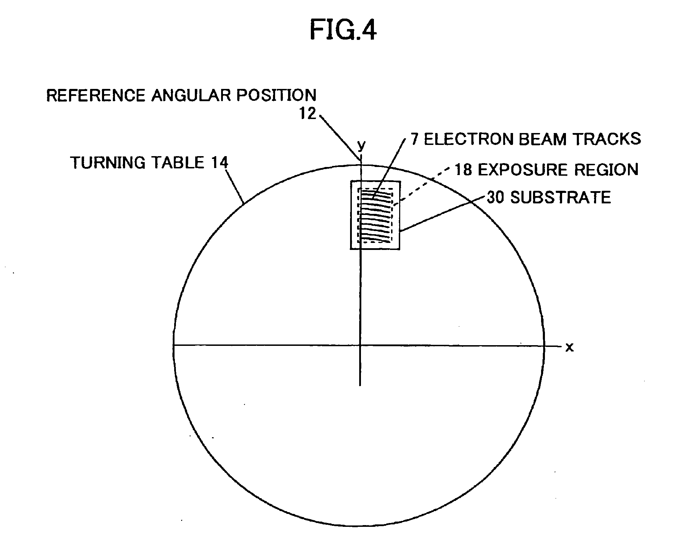

FIG. 4 is schematic view showing the process of forming a pattern by irradiating the substrate 30 with an electron beam while rotating the substrate 30 together with the turning table 14.

In FIG. 4, the reference number 12 designates a reference angular position, and the reference number 18 designates an exposure region. The exposure region 18 is a rectangle, and one side of the exposure region 18 is set at the reference angular position 12.

If the electron beam is continuously incident on the substrate 30 which is being rotated together with the turning table 14, while the translational stage 15 is being moved continuously, the electron beam 5 forms spiral tracks 7 on the substrate 30. Inside the exposure region 18, the tracks 7 of the electron beam 5 appear as arcs, and are distributed at equal intervals.

By scanning the electron beam on the substrate 30 while rotating the substrate 30, it is possible to expose a large area at one time, and this area can be several hundred times larger than the unit exposure field in the xy-stage lithography apparatus of the related art. Furthermore, by expressing the pattern to be formed with x, θ coordinates, it is possible to form a pattern of any kind of shape over a wide region easily.

Nevertheless, as described above, if the turning table 14 is controlled by CAV, the linear velocity changes along the radial directions, hence, the exposure dose of the electron beam along the radial directions cannot be constant. It may be attempted to modulate the intensity of the electron beam along the radial directions, for example, by making the intensity of the electron beam variable, but, as mentioned above, it is difficult.

Alternatively, it may be attempted to drive the turning table by CLV control in the course of exposure to keep the linear velocity to be constant at different radial positions. In this case, however, although it is possible to correctly control and detect the radial positions, because the radial position changes constantly in order to form the spiral tracks, the rotational speed of the turning table changes continuously even in the exposure region 18. For this reason, it is difficult to precisely determine angular positions. As a result, the detected angular positions involve large uncertainties, thus, even if exposure is performed in the way as shown in FIG. 2, it is difficult to obtain accuracy of the exposure position as high as that obtained in the xy-stage lithography apparatus of the related art.

It may also be attempted to detect an angle by using, for example, a rotary encoder. In this case, for example, in FIG. 2, if the diameter of the turning table 14 is 150 mm, and the exposure region is 10 mm x 20 mm, even when 100 million pulses are assigned to one revolution, at a radial position of 60 mm on the turning table, one pulse corresponds to a distance as long as 11 $\mu$m. Thus, it is impossible to obtain accuracy of the exposure position as high as that obtained in the lithography apparatus of the related art.

The method of electron-beam lithography according to the first embodiment of the present invention is proposed to solve this problem.

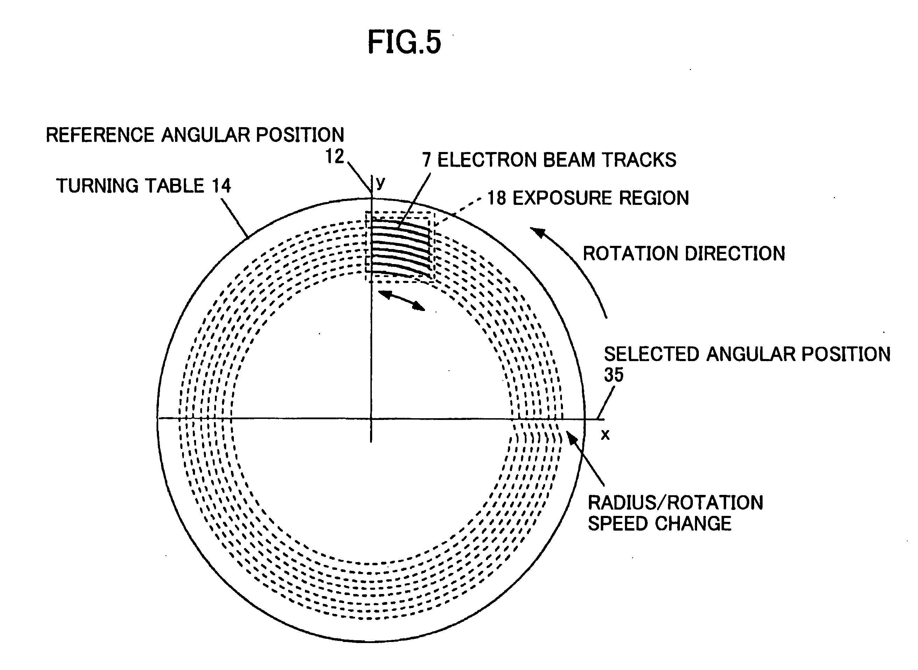

FIG. 5 is a schematic view of a pattern n exposed by the electron-beam lithography method of the present embodiment.

In FIG. 5, the reference number 35 designates a selected angular position. Preferably, the selected angular position 35 is set to be out of the exposure region 18. For example, in FIG. 5, if a pulse related to the original point of the turning table 14 is generated at the y axis, the y axis is set to be the reference angular position 12, and the x axis, that is, the angular position after the turning table 14 rotates 90 degrees from the reference angular position 12, is set to be the selected angular position 35.

The method of electron-beam lithography according to the first embodiment of the present invention is executed by using the electron-beam lithography apparatus shown in FIG. 3. In the following, the rotational speed of the turning table 14 is represented by k (rps), a radial position (that is, a radius) at the reference angular position 12 is represented by r (mm), and a linear velocity at the reference angular position 12 is represented by V (mm/s). In the present embodiment, the rotational speed k is controlled to be $V/2\pi r$ at each radius r.

The reference angular position 12 is detected from the pulse related to the original point of the turning table 14, and a pulse from a rotary encoder.

As for the method of changing the radial exposure position, as illustrated in FIG. 5, the radial position is changed at the selected angular position 35, which is at a specified position apart from the reference angular position 12, while taking into consideration the time required by radial position control.

Furthermore, in the present embodiment, the rotational speed is changed at the same time as the radial position is changed.

In FIG. 5, because the time required for changing the radial position is sufficiently short, the exposure pattern on the whole area of the substrate 30 forms approximately concentric circles.

By performing rotation control in this way, it is possible to stably control the rotational speeds at radial positions at the reference angular position 12 to be k (rps).

In FIG. 5, it is shown that the radial position changes by one pitch after one revolution. Depending on the pattern to be formed, the radial position may change by one pitch after a plurality of revolutions, or the radial position may change by multiple pitches after one revolution. Therefore, preferably, movement of the translational stage 15 is controlled so that the change of the radial position is zero or integral multiples of the pitch.

In addition, as illustrated in FIG. 5, because the rotational speed k does not change inside the exposure region 18 at any radial position, the exposure position of the electron beam 5 can be accurately expressed by using the time from the reference angular position 12 as a parameter.

Although it is shown that the starting position for counting the time is at the reference angular position 12, as illustrated in FIG. 5, this starting position may be at any other appropriate angular position.

Therefore, coordinates (x, y) of an exposure position of the electron beam 5 after time t (seconds) elapses from the reference angular position 12 can be expressed by the following equation (1).

$$(x, y) = (r*\sin(2\pi kt), r*\cos(2\pi kt)) \dots (1)$$

where, r represents a radius in units of mm.

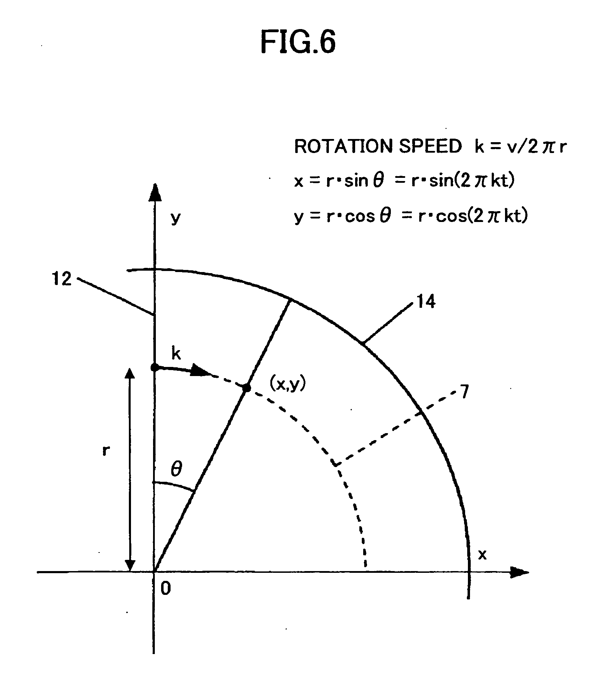

FIG. 6 is a view of a coordinate system illustrating the relation expressed by the equation (1).

By performing rotation control in this way, even in lithography using the electron beam, whose intensity is not changeable, it is possible to maintain the linear velocity to be constant at least in the exposure region 18, therefore, it is not necessary to modulate the intensity of the electron beam, and it is possible to expose a large area.

The above method is suitable for formation of a circular pattern. When forming a rectangular pattern dealt with by the xy-stage lithography apparatus, which is expressed by x, y coordinates, it is required to transform the x, y coordinates into x, θ coordinates. However, as mentioned above, uncertainties occur in this transformation. For example, the uncertainties may be at most half of the pitch.

In the present embodiment, the exposure pitch is reduced in order to reduce the uncertainties arising when transforming the x, y coordinates into x, θ coordinates. But this method of reducing the pitch has limits. The methods described in the subsequent second and third embodiments are for solving this problem, in which, when irradiating the exposure region 18 using the lithography apparatus shown in FIG. 3, the electron beam 5 is deflected in x or y directions in the exposure region 18.

Second Embodiment

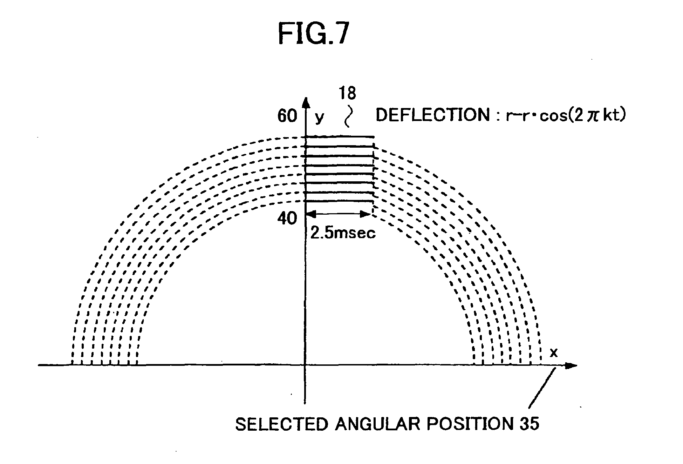

FIG. 7 is a schematic view showing tracks of the electron beam 5 in the exposure region 18, which are formed by an electron-beam lithography method according to a second embodiment of the present invention.

In the present embodiment, the same reference numbers are used for the same elements as those shown in the previous embodiment, and overlapping descriptions are omitted.

In the present embodiment, the electron beam 5 is deflected in the y direction when exposing in the exposure region 18, which is defined in the first embodiment. As illustrated in FIG. 7, the deflector 11 is controlled so that the tracks of the electron beam 5 are perpendicular to the y axis (or parallel to the x axis), which is at the reference angular position 12.

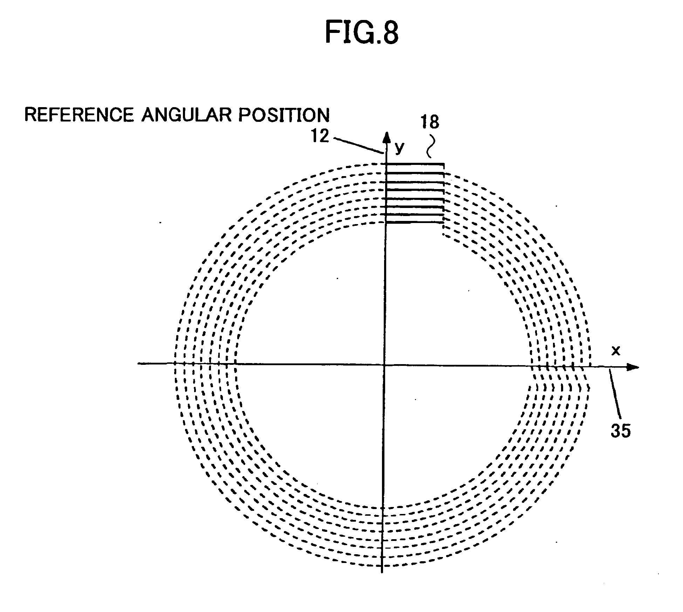

FIG. 8 is a schematic view showing the tracks of an electron beam in the exposure region 18 and over the substrate 30, according to the present embodiment.

As illustrated in FIG. 8, the radial position and the rotational speed are changed at the selected angular position 35, which is at a specified position apart from the reference angular position 12, while taking into consideration the time required by radial position control. For example, the radial position and the rotational speed can be changed at the same time.

During the above control of the deflector 11, the deflection Δy in the y direction is expressed by the following equation (2).

$$\Delta y = r - r*\cos(2\pi kt) \dots (2)$$

By defining the deflection Δy of the deflector 11 in this way, the tracks 7 of the electron beam 5 in the exposure region 18 are parallel to each other. Thus, at a radius r (mm), the coordinates (x, y) of an exposure position of the electron beam 5 after time t (seconds) elapses from the reference angular position 12 can be expressed by the following equation (3).

$$(x, y) = ((r*\sin(2\pi kt), r) \dots (3)$$

By performing exposure in this way, exposure accuracy is improved even when forming an optical element such as a diffraction grating, which requires high linearity of the pattern.

Third Embodiment

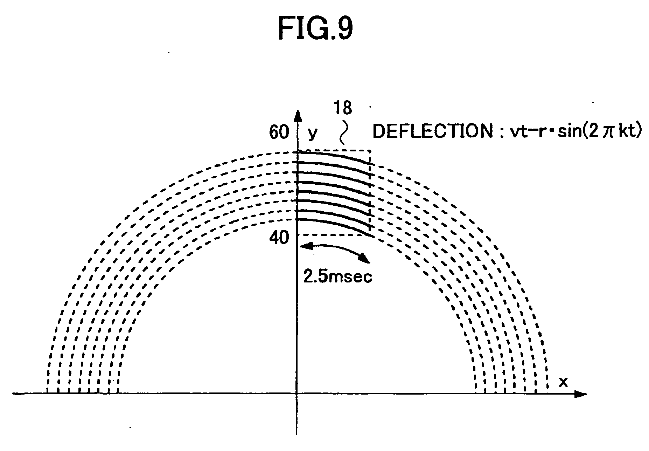

FIG. 9 is a schematic view showing tracks of the electron beam 5 in the exposure region 18, which are formed by an electron-beam lithography method according to a third embodiment of the present invention.

In the present embodiment, the same reference numbers are used for the same elements as those shown in the previous embodiments, and overlapping descriptions are omitted.

In the present embodiment, the electron beam 5 is deflected in the x direction when exposing the exposure region 18. As illustrated in FIG. 9, the deflector 11 is controlled so that the distance between the reference angular position 12 (y axis) and the position of the electron beam after a certain time interval elapses from the reference angular position 12 is constant at different radial positions in the exposure region 18.

During the above control of the deflector 11, the deflection $\Delta x$ in the x direction is expressed by the following equation (4).

$$\Delta x = Vt - r*sin(2\pi kt) \dots (4)$$

By defining the deflection $\Delta x$ of the deflector 11 in this way, the tracks 7 of the electron beam 5 in the exposure region 18 are distributed at regular intervals along the y direction. Thus, at a radius r (mm), the coordinates (x, y) of an exposure position of the electron beam 5 after time t (seconds) elapses from the reference angular position 12 can be expressed by the following equation (5).

$$(x, y) = (Vt, r*cos(2\pi kt)) \dots (5)$$

By performing exposure in this way, exposure accuracy is improved even when forming an optical element which suffers from pattern separation fluctuations, such as a diffraction grating.

Further, by applying the methods of both the second embodiment and the third embodiment, that is, deflecting the electron beam in both x and y directions, at a radius r (mm), the coordinates (x, y) of an exposure position of the electron beam 5 after time t (seconds) elapses from the reference angular position 12 can be simply expressed to be (Vt, r). As a result, in addition to an improvement of the exposure accuracy, data of drawings created by CAD or other applications, which are described with x, y coordinates, can be transformed directly to signals of the formatter 26, and thus uncertainties do not occur when transforming the x, y coordinates into x, θ coordinates.

In the xy-stage lithography apparatus of the related art, unit exposure fields, each of which is usually 0.5 mm x 0.5 mm in area, are exposed by repeating deflection in the x direction by a distance of 0.5 mm and deflection and movement in the y direction by one pitch (in this case, the deflected distance is ±0.25mm).

In contrast, by applying the methods of the second embodiment and the third embodiment, by the same quantity of deflection of the electron beam, it is possible to expose a region of 5 mm x 5 mm in area by repeating exposure over a distance of 5 mm in the x direction and movement in the y direction by one pitch.

In the present embodiment, because the deflection in the y direction results in reduction of the radius, if the radius is set to have a large offset in advance, for example, the offset is 0.25 mm in the above example, the deflection $\Delta y$ in the y direction may be 1/2. In other words, even though the electron beam is scanned by the same deflection (0.25 mm) as that in the xy-stage lithography apparatus of the related art, by setting an offset in advance, it is possible to expose a region having an area of 7 mm x 7 mm.

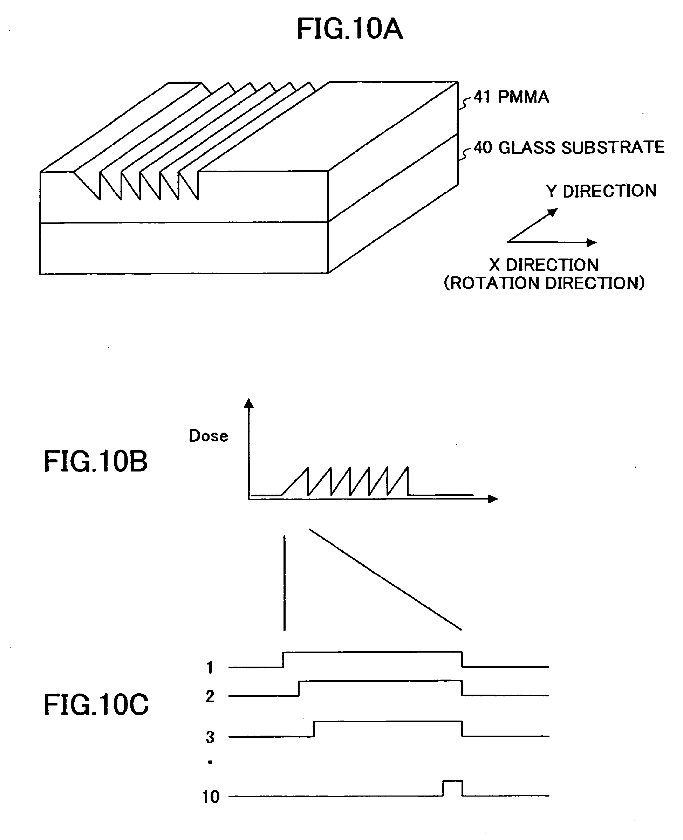

FIGs. 10A through 10C illustrate a diffraction grating formed by utilizing the methods of the second embodiment and the third embodiment, where FIG. 10A is a perspective view of the diffraction grating, FIG. 10B is a graph showing exposure dose, and FIG. 10C shows exposure pulses of different laps of a track of the electron beam.

The diffraction grating in FIG. 10A includes a glass substrate 40 and a PMMA (polymethylmethacrylate) film 41 on the glass substrate 40.

When exposing the PMMA film 41 on the glass substrate 40, as illustrated in FIG. 10B, the exposure dose is set variable. Hence, the residual film of the PMMA film 41 after development is modulated, forming a diffraction grating as shown in FIG. 10A.

The variation of the exposure dose is set in the way illustrated in FIG. 10C. In FIG. 10C, exposure is performed 10 laps by 10 laps, and the respective exposure pulses for the 10 laps are illustrated in FIG. 10C, that is, the width of the exposure pulse for the first lap is the largest, the widths of the exposure pulses for the successive laps decrease gradually, and the width of the exposure pulse for the 10th lap is the smallest.

In this way, it is possible to form a diffraction grating having a large area with high precision.

In exposures shown in FIG. 8 and FIG. 9, the initial position of the electron beam scanning in the exposure region 18 is set as the reference angular position 12. But the reference angular position 12 may also be set at other positions.

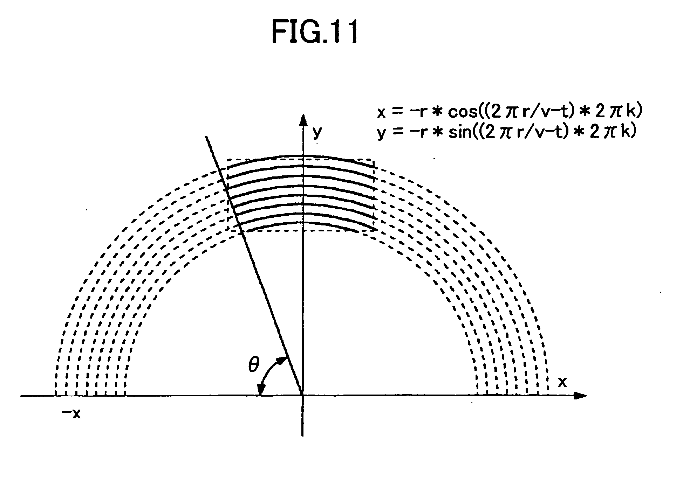

FIG. 11 is a schematic view showing another example of a pattern exposed by the electron-beam lithography methods of the present invention.

In FIG. 11, the -x direction, which is 90 degrees earlier than the exposure region 18, is set to be the reference angular position 12, thus, at a radius r (mm), the coordinates (x, y) of an exposure position after t (seconds) elapses from the reference angular position (-x axis) can be expressed by the following equation (6).

$$(x, y) =$$

$$(-r*\cos(2\pi r/V-t)* 2\pi k, -r*\sin(2\pi r/V-t)* 2\pi k) \ldots (6)$$

By performing exposure in this way, as illustrated in FIG. 11, the exposure region is two times the exposure region 18 in FIG. 8 and FIG. 9. Therefore, it is possible to easily form a long and thin optical element, such as an fθ lens having a fine diffraction pattern on its surface.

Fourth Embodiment

In the present embodiment, the same reference numbers are used for the same elements as those shown in the previous embodiments, and overlapping descriptions are omitted.

In the previous embodiments, the translational stage 15 is driven to move at a selected angular position only when necessary, and is repeatedly moved and stopped. In the present embodiment, the translational stage 15 is driven to move continuously in the course of exposure.

The translational stage 15 is controlled so that a radial position (radius) r (mm) after t (seconds) elapses can be expressed by the following equation (7).

$$r = [(t*P)/(\pi *V)+r0^2]^{1/2} \ldots (7)$$

where, P represents a pitch in units of $\mu$m, V represents a linear velocity in units of (mm/s), and r0 represents an initial exposure radius in units of (mm).

In the present embodiment, the electron beam 5 is deflected in the same way as described in the second and third embodiments. In the second and third embodiments, the translational stage 15 is moved even in the course of exposure. Assume the translational stage 15 moves through a distance Δr (displacement) after t (seconds) elapses from a radial position r1 (mm) at the reference angular position 12. The distance Δr can be expressed by the following equation (8).

$$\Delta r = [(t*P)/(\pi *V)+r1^2]^{1/2} \ldots (8)$$

For example, if the radius r1 is 50 mm, pitch P is 0.1 $\mu$m, linear velocity V is 8000 mm/s, and the area of the exposure region is 10 mm x 10 mm, the displacement Δr of the translational stage 15 is less than 7 nm. In other words, if the exposure region is small, the displacement Δr of the translational stage 15 is negligible, and the same as the second and third embodiments, by deflections in the x and y directions, data of drawings created by CAD or other applications, which are described with x, y coordinates, can be transformed directly to signals of the formatter 26.

The displacement Δr can be diminished by appropriately setting the deflection Δy in the y direction.

For example, if the deflection Δy in the y direction is defined to be expressed by the following equation (9),

$$\Delta y = r- r*\cos(2\pi kt)$$

$$+ [(t*P)/(\pi *V)+r^2]^{1/2} \ldots (9)$$

the displacement Δr vanishes.

As a result, the same as the first embodiment, in lithography, even though the same position cannot be exposed several times with intensity of the electron beam variable, the translational stage 15 moves more continuously, and when forming a pattern by switching the beam irradiation ON/OFF, it is possible to obtain a position feeding accuracy higher than that in the first embodiment, in which the translational stage 15 moves discontinuously; moreover, it does not take any time to determine the feeding position.

In the previous embodiments, there is only one exposure region on the substrate 30. According to the fourth embodiment, there may be a plurality of exposure regions on the substrate 30.

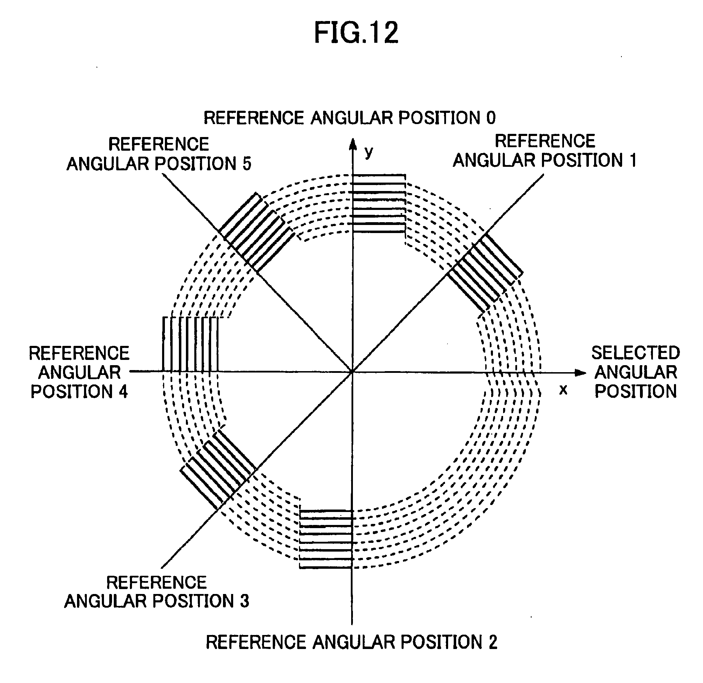

FIG. 12 is a schematic view showing an example of providing a plurality of exposure regions.

By performing exposure in this way as shown in FIG. 12, it is possible to form a plurality of optical elements at one time.

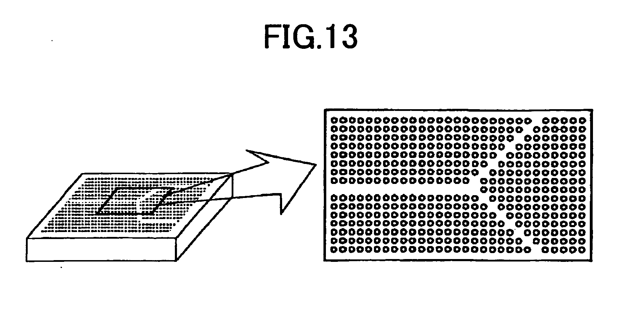

FIG. 13 is a view of a photonic crystal wave guide path formed by the method shown in FIG. 12.

In FIG. 13, an electron-beam resist is applied on a Si wafer, on which a $SiO_2$ film is formed. On the resist, a plurality of circular patterns each having a diameter of 0.2 $\mu$m are distributed at equal pitches of 0.6 $\mu$m, and the patterns shown in FIG. 13 are formed by RIE (Reactive Ion Etching).

The wave guide loss of the thus formed photonic crystal wave guide path was measured at a wavelength 1400 nm, and the result was 7 dB/mm, which is sufficiently small.

As shown above, the method of lithography of the present embodiment is suitable for forming an optical element larger than several $mm^2$ with high precision, on which many cylindrical holes, each of which is several hundred nanometers in diameter, are arranged at intervals of about several hundred nm such as a photonic crystal wave guide path.

While the present invention is described with reference to specific embodiments chosen for purpose of illustration, it should be apparent that the invention is not limited to these embodiments, but numerous modifications could be made thereto by those skilled in the art without departing from the basic concept and scope of the invention.

**Claims**

1.   An electron-beam lithography method for irradiating a rotating substrate (30) with an electron beam (5) while moving an irradiation position of the electron beam (5) on the substrate in a radial direction at predetermined pitches, said electron-beam lithography method comprising the steps of:

setting a portion of a region able to be irradiated by the electron beam to be a pattern exposure region (18);
controlling a rotational speed of the substrate (30) to be V/(2 $\pi$ r) at a radial position r at a reference angular position when the irradiation position of the electron beam (5) is in the pattern exposure region (18), where V represents a linear velocity at the reference angular position, wherein within the pattern exposure region (18) the rotational speed is constant for a given radial position;
changing the rotational speed of the substrate (30) to a value corresponding to a next radial position when the irradiation position of the electron beam (5) is out of the pattern exposure region (18) so as to keep the linear velocity V constant within the pattern exposure region (18); and
controlling the electron beam (5) intermittently according to time after changing the rotational speed relative to the reference angular position (12); wherein the deflection unit (11) is arranged to deflect the electron beam (5) in a direction parallel to the radial direction at the reference angular position (12) so that tracks of the electron beam (5) in the pattern exposure region (18) are perpendicular to the radial direction at the reference angular position (12).

2.   An electron-beam lithography method for irradiating a rotating substrate with an electron beam while moving an irradiation position of the electron beam on the substrate in a radial direction at predetermined pitches, said electron-beam lithography method comprising the steps of;

setting a portion of a region able to be irradiated by the electron beam to be a pattern exposure region;
controlling a rotational speed of the substrate to be V/(2 $\pi$ r) at a radial position r at a reference angular position when the irradiation position of the electron beam is in the pattern exposure region (18), where V represents a linear velocity at the reference angular position, wherein within the pattern exposure region (18) the rotational speed is constant for a given radial position;
changing the rotational speed to a value corresponding to a next radial position when the irradiation position of the electron beam is out of the pattern exposure region (18) so as to keep the linear velocity V constant within the pattern exposure region (18); and
controlling the electron beam intermittently according to time after changing the rotational speed relative to the reference angular position; wherein the electron beam is deflected in a direction perpendicular to the radial direction at the reference angular position (12) so that a distance from the reference angular position (12) to a position of the electron beam (5) after predetermined time elapses is constant at different radii.

**3.** The electron-beam lithography method as claimed in claim 1 or 2, wherein
the rotational speed is changed at a predetermined angular position (35) out of the pattern exposure region (18).

**4.** The electron-beam lithography method as claimed in claim 1 or 2, wherein
the irradiation position is changed at a predetermined angular position (35) out of the pattern exposure region (18).

**5.** The electron-beam lithography method as claimed in claim 3, wherein
the irradiation position is changed by a distance equalling zero or integral multiples of the pitch.

**6.** The electron-beam lithography method as claimed in claim 1 or 2, wherein
a translational stage that moves the substrate (30) in the radial directions is controlled so that a radial position r after time t elapses is expressed by

$$r = [(t*P*V) / \pi + r0^2]^{1/2},$$

where, P represents a pitch, V represents a linear velocity, and r0 represents an initial exposure radius; and
the irradiation position is changed at a predetermined angular position (35) out of the pattern exposure region (18).

**7.** The electron-beam lithography method as claimed in claim 1 or 2, wherein
a plurality of the reference angular positions are arranged; and
a plurality of the pattern exposure regions are arranged.

**8.** An electron-beam lithography apparatus arranged to generate an electron beam to irradiate a surface of a rotating substrate (30) comprising a pattern exposure region (18) to form a pattern, said electron-beam lithography apparatus comprising:

a rotation stage (14) arranged to rotate the substrate;
a translational stage (15) arranged to move the substrate along a radial direction;
a detection unit (3) arranged to detect a reference angular position of the translational stage;
a rotation controller (22) arranged to detect a radial position of an irradiation position of the electron beam (5) at a reference angular position, control a rotation speed of the substrate (30) to be V/2πr at a radial position r at the reference angular position when the irradiation position of the electron-beam (5) is in the pattern exposure region (18), where V represents a linear velocity at the reference angular position, and wherein within the pattern exposure region (18) the rotation speed is constant for given radial position, wherein the rotation controller (22) is further arranged to change a rotational speed of the substrate (30) based on the detected radial position to a value corresponding to a next radial position when the irradiation position of the electron-beam (5) is out of the pattern exposure region (18) so as to keep the linear velocity V constant within the pattern exposure region (18);
a deflection unit (11) arranged to deflect that electron beam (5) in the radial directions and in a rotational direction; and
an exposure unit (1) arranged to expose the pattern exposure region (18) with the electron beam in a tangential direction of the rotation stage according to time elapsed relative to the reference angular position, said pattern exposure region (18) being a portion of a region able to be irradiated by the electron beam; wherein the deflection unit (11) is arranged to deflect the electron beam (5) in a direction parallel to the radial direction at the reference angular position (12) so that tracks of the electron beam (5) in the pattern exposure region (18) are perpendicular to the radial direction at the reference angular position (12).

**9.** An electron-beam lithography apparatus arranged to generate an electron beam to irradiate a surface of a rotating substrate (30) comprising a pattern exposure region (18) to form a pattern, said electron-beam lithography apparatus comprising:

a rotation stage (14) arranged to rotate the substrate;
a translational stage (15) arranged to move the substrate along a radial direction;
a detection unit (3) arranged to detect a reference angular position of the translational stage;
a rotation controller (22) arranged to detect a radial position of an irradiation position of the electron beam (5) at a reference angular position, control a rotation speed of the substrate (30) to be V/2πr at a radial position r at the reference angular position when the irradiation position of the electron-beam (5) is in the pattern exposure region (18), where V represents a linear velocity at the reference angular position, and wherein within the pattern exposure region (18) the rotation speed is constant for given radial position, wherein the rotation controller (22) is further arranged to change a rotational speed of the substrate (30) based on the detected radial position to a value corresponding to a next radial position when the irradiation position of the electron-beam (5) is out of the pattern exposure region (18) so as to keep the linear velocity V constant within the pattern exposure region (18);

a deflection unit (11) arranged to deflect that electron beam (5) in the radial directions and in a rotational direction; and

an exposure unit (1) arranged to expose a pattern exposure region with the electron beam in a tangential direction of the rotation stage according to time elapsed relative to the reference angular position, said pattern exposure region being a portion of a region able to be irradiated by the electron beam; wherein the deflection unit (11) is arranged to deflect the electron-beam (5) in a direction perpendicular to the radial direction at the reference angular position (12) so that a distance from the reference angular position (12) to a position of the electron beam (5) after predetermined time elapses is constant at different radii.

## Patentansprüche

1. Elektronenstrahllithographie-Verfahren, um ein rotierendes Substrat (30) mit einem Elektronenstrahl (5) zu bestrahlen, während eine Bestrahlungsposition des Elektronenstrahls (5) in einer radialen Richtung in vorgegebenen Schrittwelten bewegt wird, wobei das Elektronenstrahllithographie-Verfahren die folgenden Schritte umfasst:

   Festlegen eines Abschnitts eines Bereichs, der durch den Elektronenstrahl bestrahlt werden kann, als einen Musterbelichtungsbereich (18);

   Steuern einer Rotationsgeschwindigkeit des Substrats (30) auf V/(2πr) an einer radialen Position r an einer Referenzwinkelposition, wenn die Bestrahlungsposition des Elektronenstrahls (5) in dem Musterbelichtungsbereich (18) liegt, wobei V eine lineare Geschwindigkeit an der Referenzwinkelposition repräsentiert, wobei innerhalb des Musterbelichtungsbereichs (18) die Drehgeschwindigkeit für eine gegebene radiale Position konstant ist;

   Ändern der Drehgeschwindigkeit des Substrats (30) auf einen Wert, der einer nächsten radialen Position entspricht, wenn die Bestrahlungsposition des Elektronenstrahls (5) außerhalb des Musterbelichtungsbereichs (18) liegt, um die lineare Geschwindigkeit V innerhalb des Musterbelichtungsbereichs (18) konstant zu halten; und

   zeitlich intermittierendes Steuern des Elektronenstrahls (5) nach der Änderung der Drehgeschwindigkelt relativ zu der Referenzwinkelposition (12); wobei die Ablenkungseinhelt (11) dazu ausgelegt ist, den Elektronenstrahl (5) in einer Richtung parallel zu der radialen Richtung an der Referenzwinkelposition (12) abzulenken, so dass Bahnen des Elektronenstrahls (5) in dem Musterbelichtungsbereich (18) zu der radialen Richtung an der Referenzwinkelposition (12) senkrecht sind.

2. Elektronenstrahllithographie-Verfahren, um ein rotierendes Substrat mit einem Elektronenstrahl zu bestrahlen, während eine Bestrahlungsposition des Elektronenstrahls auf dem Substrat in einer radialen Richtung in vorgegebenen Schrittweiten bewegt wird, wobei das Elektronenstrahllithographie-Verfahren die folgenden Schritte umfasst:

   Festlegen eines Abschnitts eines Bereichs, der durch den Elektronenstrahl bestrahlt werden kann, als einen Musterbelichtungsbereich;

   Steuern einer Drehgeschwindigkeit des Substrats auf V/(2πr) an einer radialen Position r an einer Referenzwinkelposition, wenn die Bestrahlungsposition des Elektronenstrahls in dem Musterbelichtungsbereich (18) liegt, wobei V eine lineare Geschwindigkeit an der Referenzwinkelposition darstellt, wobei in dem Musterbelichtungsbereich (18) die Drehgeschwindigkeit für eine gegebene radiale Position konstant ist;

   Ändern der Drehgeschwindigkeit auf einen Wert, der einer nächsten radialen Position entspricht, wenn die Bestrahlungsposition des Elektronenstrahls außerhalb des Musterbelichtungsbereichs (18) liegt, um die lineare Geschwindigkeit V innerhalb des Musterbelichtungsbereichs (18) konstant zu halten, und

   zeitlich intermittierendes Steuern des Elektronenstrahls nach der Änderung der Drehgeschwindigkeit relativ zu der Referenzwinkelposition; wobei der Elektronenstrahl in einer Richtung senkrecht zu der radialen Richtung an der Referenzwinkelposition (12) abgelenkt wird, so dass ein Abstand von der Referenzwinkelposition (12) zu einer Position des Elektronenstrahls (12) nach Verstreichen einer vorgegebenen Zeit bei unterschiedlichen Radien konstant ist.

**3.** Elektronenstrahillthographie-Verfahren nach Anspruch 1 oder 2, wobei
die Drehgeschwindigkeit an einer vorgegebenen Winkelposition (35) außerhalb des Musterbelichtungsbereichs (18) geändert wird.

**4.** Elektronenstrahilithographie-Verfahren nach Anspruch 1 oder 2, wobei
die Bestrahlungsposition an einer vorgegebenen Winkelposition (35) außerhalb des Musterbelichtungsbereichs (18) geändert wird.

**5.** Elektronenstrahllithographie-Verfahren nach Anspruch 3, wobei
die Bestrahlungsposition um eine Strecke geändert wird, die gleich Null oder einem ganzzahligen Vielfachen der Schrittweite ist.

**6.** Elektronenstrahllithographie-Verfahren nach Anspruch 1 oder 2, wobei
eine Translationsstufe, die das Substrat (30) in den radialen Richtungen bewegt, in der Weise gesteuert wird, dass eine radiale Position r nach Verstreichen einer Zeit t gegeben ist durch

$$r = \left[ (t \cdot P \cdot V) / \pi + r0^2 \right]^{1/2}$$

wobei P eine Schrittweite repräsentiert, V eine lineare Geschwindigkeit repräsentiert und r0 einen anfänglichen Belichtungsradius repräsentiert; und
die Bestrahlungsposition an einer vorgegebenen Winkelposition (35) außerhalb des Musterbelichtungsbereichs (18) geändert wird.

**7.** Elektronenstrahilithographie-Verfahren nach Anspruch 1 oder 2, wobei
mehrere Referenzwinkelpositionen vorgesehen sind; und
mehrere Musterbelichtungsbereiche vorgesehen sind.

**8.** Elektronenstrahllithographie-Vorrichtung, die dazu ausgelegt ist, einen Elektronenstrahl zu erzeugen, um eine Oberfläche eines rotierenden Substrats (30), das einen Musterbelichtungsbereich (18) aufweist, zu bestrahlen, um ein Muster zu bilden, wobei die Elektronenstrahllithographie-Vorrichtung umfasst:

eine Rotationsstufe (14), die dazu ausgelegt ist, das Substrat zu drehen;
eine Translationsstufe (16), die dazu ausgelegt ist, das Substrat in einer radialen Richtung zu bewegen:

eine Detektionseinheit (3), die dazu ausgelegt Ist, eine Referenzwinkelposition der Translationsstufe zu detektieren;
eine Rotationssteuereinheit (22), die dazu ausgelegt ist, eine radiale Position einer Bestrahlungsposition des Elektronenstrahls (5) an einer Referenzwinkelposition zu detektieren, eine Drehgeschwindigkeit des Substrats (30) auf V/2πr an einer radialen Position r an der Referenzwinkelposition zu steuern, wenn die Bestrahlungsposition des Elektronenstrahls (5) in dem Musterbelichtungsbereich (18) liegt, wobei V eine lineare Geschwindigkeit an der Referenzwinkelposition repräsentiert und wobei innerhalb des Musterbelichtungsbereichs (18) die Drehgeschwindigkeit für eine gegebene radiale Position konstant ist, wobei die Rotationssteuereinheit (22) ferner dazu ausgelegt ist, eine Drehgeschwindigkeit des Substrats (30) auf der Grundlage der detektierten radialen Position auf einen Wert zu ändern, der einer nächsten radialen Position entspricht, wenn die Bestrahlungsposition des Elektronenstrahls (5) außerhalb des Musterbelichtungsbereichs (18) liegt, um die lineare Geschwindigkeit V innerhalb des Musterbelichtungsbereichs (18) konstant zu halten;
eine Ablenkungseinheit (11), die dazu ausgelegt ist, den Elektronenstrahl (5) in den radialen Richtungen und in einer Drehrichtung abzulenken; und
eine Belichtungseinheit (1), die dazu ausgelegt ist, den Musterbelichtungsbereich (18) mit dem Elektronenstrahl in einer tangentialen Richtung der Rotationsstufe in Übereinstimmung mit einer verstrichenen Zeit relativ zu der Referenzwinkelposition zu belichten, wobei der Musterbelichtungsbereich (18) ein Abschnitt eines Bereichs ist, der durch den Elektronenstrahl bestrahlt werden kann; wobei die Ablenkungseinheit (11) dazu ausgelegt ist, den Elektronenstrahl (5) in einer Richtung parallel zu der radialen Richtung an der Referenzwinkelposition (12) abzulenken, so dass Bahnen des Elektronenstrahls (5) in dem Musterbelichtungsbereich (18) zu der radialen Richtung an der Referenzwinkelposition (12) senkrecht sind.

9. Elektronenstrahllithographie-Vorrichtung, die dazu ausgelegt ist, einen Elektronenstrahl zu erzeugen, um eine Oberfläche eines rotierenden Substrats (30), das einen Musterbelichtungsbereich (18) aufweist, zu bestrahlen, um ein Muster zu bilden, wobei die Elektronenstrahllithographie-Vorrichtung umfasst:

eine Rotationsstufe (14), die dazu ausgelegt ist, das Substrat zu drehen;
eine Translationsstufe (15), die dazu ausgelegt ist, das Substrat in einer radialen Richtung zu bewegen;
eine Detektionseinheit (3), die dazu ausgelegt ist, eine Referenzwinkelposition der Translationsstufe zu detektieren;
eine Rotationssteuereinheit (22), die dazu ausgelegt ist, eine radiale Position einer Bestrahlungsposition des Elektronenstrahls (5) an einer Referenzwinkelposition zu detektieren und eine Drehgeschwindigkeit des Substrats (30) auf V/2πr an einer radialen Position r an der Referenzwinkelposition zu steuern, wenn die Bestrahlungsposition des Elektronenstrahls (5) in dem Musterbelichtungsbereich (18) liegt, wobei V eine lineare Geschwindigkeit an der Referenzwinkelposition repräsentiert und wobei in dem Musterbelichtungsbereich (18) die Drehgeschwindigkeit für eine gegebene radiale Position konstant ist, wobei die Drehsteuereinheit (22) ferner dazu ausgelegt ist, eine Drehgeschwindigkeit des Substrats (30) anhand der detektierten radialen Position auf einen Wert zu ändern, der einer nächsten radialen Position entspricht, wenn die Bestrahlungsposition des Elektronenstrahls (5) außerhalb des Musterbelichtungsbereichs (18) liegt, um die lineare Geschwindigkeit V innerhalb des Musterbelichtungsbereichs (18) konstant zu halten;
eine Ablenkungseinheit (11), die dazu ausgelegt ist, den Elektronenstrahl (5) in den radialen Richtungen und in einer Drehrichtung abzulenken; und
eine Belichtungseinheit (1), die dazu ausgelegt ist, einen Musterbelichtungsbereich mit dem Elektronenstrahl in einer tangentialen Richtung der Rotationsstufe in Übereinstimmung mit einer verstrichenen Zeit relativ zu der Referenzwinkelposition zu belichten, wobei der Musterbelichtungsbereich ein Abschnitt eines Bereichs ist, der durch den Elektronenstrahl bestrahlt werden kann; wobei die Ablenkungseinheit (11) dazu ausgelegt ist, den Elektronenstrahl (5) in einer Richtung senkrecht zu der radialen Richtung an der Referenzwinkelposition (12) abzulenken, so dass ein Abstand von der Referenzwinkelposition (12) zu einer Position des Elektronenstrahls (5) nach Verstreichen einer vorgegebenen Zeit bei verschiedenen Radien konstant ist.

## Revendications

1. Procédé de lithographie par faisceau d'électrons pour irradier un substrat tournant (30) par un faisceau d'électrons (5) tout en déplaçant une position d'irradiation du faisceau d'électrons (5) sur le substrat dans une direction radiale à des pas prédéterminés, ledit procédé de lithographie par faisceau d'électrons comportant les étapes consistant à :

déterminer une partie d'une région pouvant être irradiée par le faisceau d'électrons pour être une région d'exposition de motif (18) ;
contrôler une vitesse de rotation du substrat (30) pour être V/(2πr) en une position radiale r à une position angulaire de référence lorsque la position d'irradiation du faisceau d'électrons (5) se trouve dans la région d'exposition de motif (18), où V représente une vitesse linéaire à la position angulaire de référence, où, dans la région d'exposition de motif (18), la vitesse de rotation est constante pour une position radiale donnée ;
changer la vitesse de rotation du substrat (30) à une valeur correspondant à une position radiale suivante lorsque la position d'irradiation du faisceau d'électrons (5) se trouve hors de la région d'exposition de motif (18) de manière à maintenir la vitesse linéaire V constante dans la région d'exposition de motif (18) ; et
contrôler le faisceau d'électrons (5) par intermittence selon un temps après le changement de la vitesse de rotation par rapport à la position angulaire de référence (12) ; où l'unité de déviation (11) est agencée pour dévier le faisceau d'électrons (5) dans une direction parallèle à la direction radiale à la position angulaire de référence (12) de sorte que les pistes du faisceau d'électrons (5) dans la région d'exposition de motif (18) sont perpendiculaires à la position radiale à la position angulaire de référence (12).

2. Procédé de lithographie par faisceau d'électrons pour irradier un substrat tournant par un faisceau d'électrons tout en déplaçant une position d'irradiation du faisceau d'électrons sur le substrat dans une direction radiale à des pas prédéterminés, ledit procédé de lithographie par faisceau d'électrons comportant les étapes consistant à :

déterminer une partie d'une région pouvant être irradiée par le faisceau d'électrons pour être une région d'exposition de motif ;
contrôler une vitesse de rotation du substrat pour être V/(2πr) à une position radiale r à une position angulaire de référence lorsque la position d'irradiation du faisceau d'électrons se trouve dans la région d'exposition de

EP 1 517 356 B1

motif (18), où V représente une vitesse linéaire à la position angulaire de référence, où, dans la région d'exposition de motif (18), la vitesse de rotation est constante pour une position radiale donnée ;

changer la vitesse de rotation à une valeur correspondant à une position radiale suivante lorsque la position d'irradiation du faisceau d'électrons se trouve hors de la région d'exposition de motif (18) de manière à maintenir la vitesse linéaire V constante dans la région d'exposition de motif (18) ; et

contrôler le faisceau d'électrons par intermittence selon un temps après un changement de vitesse de rotation par rapport à la position angulaire de référence; où le faisceau d'électrons est dévié dans une direction perpendiculaire à la direction radiale à la position angulaire de référence (12) de sorte qu'une distance de la position angulaire de référence (12) à une position du faisceau d'électrons (5), après qu'un temps prédéterminé se soit écoulé, est constante à différents rayons.

3. Procédé de lithographie par faisceau d'électrons selon la revendication 1 ou 2, dans lequel la vitesse de rotation est changée à une position angulaire prédéterminée (35) hors de la région d'exposition de motif (18).

4. Procédé de lithographie par faisceau et d'électrons selon la revendication 1 ou 2, dans lequel la position d'irradiation est modifiée à une position angulaire prédéterminée (35) hors de la région d'exposition de motif (18).

5. Procédé de lithographie par faisceau d'électrons selon la revendication 3, dans lequel la position d'irradiation est modifiée d'une distance égale à zéro ou à des multiples entiers du pas.

6. Procédé de lithographie par faisceau d'électrons selon la revendication 1 ou 2, dans lequel un étage de translation qui déplace le substrat (30) dans les directions radiales est contrôlé de sorte qu'une position radiale r, après qu'un temps t est écoulé, est exprimée par

$$r = [(t*P*V)/\pi + r0^2]^{1/2},$$

où P représente un pas, V représente une vitesse linéaire, et r0 représente un rayon d'exposition initial ; et la position d'irradiation est modifiée à une position angulaire prédéterminée (35) hors de la région d'exposition de motif (18).

7. Procédé de lithographie par faisceau d'électrons selon la revendication 1 ou 2, dans lequel une pluralité de positions angulaires de référence sont agencées ; et une pluralité de régions d'exposition de motif sont agencées.

8. Appareil de lithographie par faisceau d'électrons disposé pour générer un faisceau d'électrons pour irradier une surface d'un substrat tournant (30) comportant une région d'exposition de motif (18) pour former un motif, ledit appareil de lithographie par faisceau d'électrons comportant :

un étage de rotation (14) disposé pour faire tourner le substrat ;
un étage de translation (15) agencé pour déplacer le substrat le long d'une direction radiale ;
une unité de détection (3) agencée pour détecter une position angulaire de référence de l'étage de translation ;
un contrôleur de rotation (22) agencé pour détecter une position radiale d'une position d'irradiation du faisceau d'électrons (5) à une position angulaire de référence, contrôler une vitesse de rotation du substrat (30) pour être V/2πr à une position radiale r à la position angulaire de référence lorsque la position d'irradiation du faisceau d'électrons (5) se trouve dans la région d'exposition de motif (18), où V représente une vitesse linéaire à la position angulaire de référence, et où, dans la région d'exposition de motif (18), la vitesse de rotation est constante pour une position radiale donnée, où le contrôleur de rotation (22) est en outre agencé pour changer une vitesse de rotation du substrat (30) en fonction de la position radiale détectée par rapport à une valeur correspondant à une position radiale suivante lorsque la position d'irradiation du faisceau d'électrons (5) se trouve hors de la région d'exposition de motif (18) de manière à maintenir la vitesse linéaire V constante à l'intérieur de la région d'exposition de motif (18) ;
une unité de déviation (11) agencée pour dévier ce faisceau d'électrons (5) dans les directions radiales et dans une direction de rotation ; et
une unité d'exposition (1) agencée pour exposer la région d'exposition de motif (18) au faisceau d'électrons dans une direction tangentielle de l'étage de rotation conformément à un temps écoulé par rapport à la position angulaire de référence, ladite région d'exposition de motif (18) étant une partie d'une région pouvant être irradiée par le faisceau d'électrons ; où l'unité de déviation (11) est agencée pour dévier le faisceau d'électrons (5) dans une direction parallèle à la direction radiale à la position angulaire de référence (12) de sorte que les pistes du faisceau d'électrons (5) dans la région d'exposition de motif (18) sont perpendiculaires à la direction radiale à la position angulaire de référence (12).

9. Appareil de lithographie par faisceau d'électrons agencé pour générer un faisceau d'électrons pour irradier une surface d'un substrat tournant (30) comportant une région d'exposition de motif (18) pour former un motif, ledit appareil de lithographie par faisceau d'électrons comportant :

un étage de rotation (14) agencé pour faire tourner le substrat ;

un étage de translation (15) agencé pour déplacer le substrat le long d'une direction radiale ;

une unité de détection (3) agencée pour détecter une position angulaire de référence d'un étage de translation ;

un contrôleur de rotation (22) agencé pour détecter une position radiale d'une position d'irradiation du faisceau d'électrons (5) en une position angulaire de référence, contrôler une vitesse de rotation du substrat (30) pour être V/2πr en une position radiale r à la position angulaire de référence lorsque la position d'irradiation du faisceau d'électrons (5) se trouve dans la région d'exposition de motif (18), où V représente une vitesse linéaire à la position angulaire de référence, et où, dans la région d'exposition de motif (18), la vitesse de rotation est constante pour une position radiale donnée, où le contrôleur de rotation (22) est en outre agencé pour changer une vitesse de rotation du substrat (30) en fonction de la position radiale détectée à une valeur correspondant à une position radiale suivante lorsque la position d'irradiation du faisceau d'électrons (5) se trouve hors de la région d'exposition de motif (18) de manière à maintenir la vitesse linéaire V constante à l'intérieur de la région d'exposition de motif (18) ;

une unité de déviation (11) agencée pour dévier ce faisceau d'électrons (5) dans les directions radiales et dans une direction de rotation ; et

une unité d'exposition (1) agencée pour exposer une région d'exposition de motif au faisceau d'électrons dans une direction tangentielle de l'étage de rotation conformément à un temps écoulé par rapport à la position angulaire de référence, ladite région d'exposition de motif étant une partie d'une région pouvant être irradiée par le faisceau d'électrons; où l'unité de déviation (11) est agencée pour dévier le faisceau d'électrons (5) dans une direction perpendiculaire à la direction radiale à la position angulaire de référence (12) de sorte qu'une distance de la position angulaire de référence (12) à une position du faisceau d'électrons (5), après qu'un temps prédéterminé se soit écoulé, est constante à des rayons différents.

# FIG.1

# FIG.2

FIG.3

# FIG.4

REFERENCE ANGULAR POSITION

TURNING TABLE 14

12

y

7 ELECTRON BEAM TRACKS

18 EXPOSURE REGION

30 SUBSTRATE

x

# FIG.5

REFERENCE ANGULAR POSITION 12

TURNING TABLE 14

7 ELECTRON BEAM TRACKS

18 EXPOSURE REGION

ROTATION DIRECTION

SELECTED ANGULAR POSITION 35

RADIUS/ROTATION SPEED CHANGE

y

x

EP 1 517 356 B1

# FIG.6

ROTATION SPEED $k = v/2\pi r$

$x = r \cdot \sin \theta = r \cdot \sin(2\pi kt)$

$y = r \cdot \cos \theta = r \cdot \cos(2\pi kt)$

# FIG.7

60 | y | 18 | DEFLECTION : r−r·cos(2 π kt)

40

2.5msec

x

SELECTED ANGULAR POSITION 35

# FIG.8

REFERENCE ANGULAR POSITION

# FIG.9

# FIG.10A

41 PMMA

40 GLASS SUBSTRATE

Y DIRECTION

X DIRECTION
(ROTATION DIRECTION)

Dose

## FIG.10B

## FIG.10C

1

2

3

.

10

# FIG.11

$$x = -r * \cos((2\pi r/v - t) * 2\pi k)$$
$$y = -r * \sin((2\pi r/v - t) * 2\pi k)$$

# FIG.12

REFERENCE ANGULAR POSITION 0

REFERENCE ANGULAR POSITION 5

REFERENCE ANGULAR POSITION 1

y

REFERENCE ANGULAR POSITION 4

SELECTED ANGULAR POSITION

x

REFERENCE ANGULAR POSITION 3

REFERENCE ANGULAR POSITION 2

EP 1 517 356 B1

# FIG.13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7294730 A
- JP 2853659 B
- JP 2000207738 A
- US 6414916 B

**Non-patent literature cited in the description**

- **OGATA S. et al.** Electron-beam writing system and its application to large and high density diffractive optic elements. *Applied Optics, OSA, Optical Society of America,* 01 April 1994, vol. 33 (10), 2032-2038